# EUROPEAN PATENT SPECIFICATION

(11) **EP 1 733 245 B1**
(45) Date of publication and mention of the grant of the patent: **14.05.2008**
(21) Application number: 05718539.9
(22) Date of filing: 21.03.2005
(51) Int. Cl.: G01R 33/422

(54) **SYSTEM FOR MAGNETIC RESONANCE IMAGING**
SYSTEM ZUR MAGNETRESONANZABBILDUNG
SYSTEME D'IMAGERIE PAR RESONANCE MAGNETIQUE

(30) Priority: 29.03.2004 EP 04101282
(43) Date of publication of application: 20.12.2006
(73) Proprietor: Koninklijke Philips Electronics N.V., 5621 BA Eindhoven (NL)
(72) Inventor: FUDERER, Miha, NL-5656 AA Eindhoven (NL); DONDERS, Frans, P., A., J., M., NL-5656 AA Eindhoven (NL)
(74) Representative: Cohen, Julius Simon
(86) International application number: PCT/IB2005/050960
(87) International publication number: WO 2005/093450

(56) References cited:
- US-A- 5 017 872
- HAYES C E: "An adjustable RF coil loading device." MAGNETIC RESONANCE IMAGING. 1993, vol. 11, no. 1, 1993, pages 81-86, XP002329459 ISSN: 0730-725X
- FOO T K F ET AL: "REDUCTION OF RF PENETRATION EFFECTS IN HIGH FIELD IMAGING" MAGNETIC RESONANCE IN MEDICINE, ACADEMIC PRESS, DULUTH, MN, US, vol. 23, no. 2, 1 February 1992 (1992-02-01), pages 287-301, XP000261762 ISSN: 0740-3194
- HAYES C E ET AL: "An efficient, highly homogeneous radiofrequency coil for whole-body NMR imaging at 1.5 T" JOURNAL OF MAGNETIC RESONANCE USA, vol. 63, no. 3, July 1985 (1985-07), pages 622-628, XP008047553 ISSN: 0022-2364

## Description

The invention relates to a system for magnetic resonance imaging, comprising a substantially cylindrical cavity, wherein the cavity has an axis of symmetry in the direction of a z-axis, wherein a subject can be examined within the cavity, and wherein the subject has a conductance which is not isotropic in an xy-plane which is perpendicular to the z-axis.

The system can be an MRI apparatus or a radio frequency (RF) coil, wherein the latter can be used in NMR apparatus and in imaging systems based on NMR such as magnetic resonance imaging (MRI) or functional magnetic resonance imaging (fMRI).

For medical diagnosis images of tissue within the human body are often desired. For this purpose (nuclear) magnetic resonance imaging (MRI) has been used for roughly 30 years. This technology makes use of the fact that atoms, for example hydrogen atoms representing roughly 95 % of the human body, may have an odd number of nucleons. In this case the atom has a nuclear spin.

When the atom is exposed to an external magnetic field *̅B̅*̅₀, the spin can be aligned either parallel or antiparallel to the magnetic field axis. These two possibilities to align the spins represent two energy levels of the formerly degenerated Kramer dublett. Due to the Boltzmann statistic the two energy levels have a different population such that the subject to be examined has a bulk magnetisation *M̅. M̅* is parallel to the field *̅B̅*̅₀.

If the subject to be examined is subjected to an additional magnetic field *̅B̅*̅₁ which is not parallel to the field *̅B̅*̅₀, then the magnetisation *̅M̅*̅ is tilted out of the parallel configuration with *̅B̅*̅₀. The magnetisation then precesses about the *̅B̅*̅₀ -axis with the Larmor frequency ω = γ*B*_{0 -} γ is the gyromagnetic ratio which is characteristic for every atom. For hydrogen atoms the Larmor frequency is 128 MHz if the magnetic field strength is 3 T.

Applying a magnetic field *̅B̅*̅₁ is normally done by coupling an RF wave into the subject to be examined, wherein the direction of the magnetic field vector *̅B̅*̅₁ is perpendicular to *̅B̅*̅₀, and wherein the frequency corresponds to the Larmor frequency of the atom under consideration. For the purposes of this disclosure, a radio frequency is considered to include frequencies between about 1 MHz to about 100 GHz.

If the RF wave is coupled into the sample the magnetisation is tilted out of the parallel configuration with *̅B̅*̅₀ as described above. Then a relaxation sets in such that the magnetisation *̅M̅*̅ is parallel again to the magnetic field *̅B̅*̅₀ after a certain relaxation time. Studying the relaxation times in detail makes it possible to derive a spatially resolved image of the subject to be examined. One possibility to do this is to perform a Fourier transformation of the time dependent spin-spin relaxation time.

In order to get an accurate image of the subject to be examined the bulk magnetisation *̅M̅*̅ must have a well-defined angle α with respect to the rest-state magnetisation for all points in space after the application of the RF pulse. The rest-state magnetisation is parallel to *̅B̅*̅₀. If, however, the RF field is spatially inhomogeneous, then a spectrum of angles α leads to a spectrum of spin-spin relaxation times. This however leads to an image with some intensity variations. As the intensity variations do not reflect variations in the properties of the tissue this may hamper the diagnosis. This is why an RF coil for NMR purposes must be designed to produce a spatially homogeneous magnetic field. Inhomogeneity may be caused by the design of the coil itself, or may be caused by the sample being positioned within the RF coil.

Numerous attempts are known in the prior art to improve the homogeneity of an RF coil. US 5,017,872 for example addresses the problem of inhomogeneity caused by the sample within the coil. The authors of this patent suggest to place a high permittivity material between the coil and the surrounding shield to reduce radial variations of the magnetic field of the cylindrical coil. This compensates for a contribution to inhomogeneity caused by the permittivity of the subject to be examined.

A similar approach is used by US 6,633,161 B1 which discloses an RF coil for an imaging system. The coil has a dielectric filled cavity formed by a surrounding conducting enclosure. In addition, a head of a patient to be examined may be positioned on a dielectric pillow to manipulate the RF magnetic flux in the region of interest in the patients head.

Increasing the magnetic field strength helps to achieve an increased signal-to-noise ratio and to increase the spatial resolution. In systems with magnetic fields of at least 3 tesla and with body sizes of 30 cm or more, the wavelength of the RF-field is roughly of the same order as the size of the human body, or even smaller. This leads to an inhomogeneous *̅B̅*̅₁ -field because of eddy currents induced in the human body by the RF field, and because of dielectric reflections and the like. This inhomogeneity is much higher than in the case of lower field strengths.

It is an object of the invention to provide a system for magnetic resonance imaging of the kind mentioned in the opening paragraph with an improved homogeneity for high field strengths, particularly for field strengths at or above 3 tesla.

In order to achieve said object a system for magnetic resonance imaging in accordance with the invention is characterized in that an electrically conductive material is placed within the cavity, wherein the material has a conductivity and a thickness which render the total conductance in the xy-plane within the cavity to be isotropic.

The invention rests on the idea that an additional contribution to the inhomogeneity of an RF field arises because the subject within the cavity renders the electric conductance within the cavity to be anisotopic.

In the following the description will only refer to the case in which a person or an animal and thus a "subject" is examined in the cavity. The invention however is not restricted to this case, as the man skilled in the art will easily understand that it is also possible to examine "objects" in the cavity such as plants or other non-living material.

If a cylindrical cavity is chosen which has an axis of symmetry which is defined to be the z-axis, the conductance within the cavity in a plane perpendicular to the above-mentioned z-axis is not isotopic due to the subject to be examined. This is the case because the subject is non-cylindrical and has a conductivity σ ≠ 0.

The above-mentioned plane perpendicular to the z-axis will be called the xy-plane. The x-axis, the y-axis and the z-axis represent a three-dimensional coordinate system with axes which are mutually orthogonal to each other.

The electric conductivity σ of the subject to be examined is responsible for an attenuation of the RF field. On a microscopic scale the RF wave is described by a damped amplitude which leads to a limited penetration of the wave into the subject. The degree of attenuation however is not spatially uniform within the cavity when the subject to be examined is positioned within the cavity. The underlying reason is the spatial extension of the subject to be examined.

If a patient is positioned within the cavity, he normally lies on a substantially plane surface of a patients bed. The normal to the patients bed is chosen to be the y-axis. The body of a patient has a larger extension in the direction of the x-axis than in the direction of the y-axis. The x-axis lies in the substantially plane surface representing the patient's bed, as can be derived from the explanations above. This often leads to an attenuation of the RF field which is larger in the x-direction than in the y-direction.

In order to compensate for this effect an electrically conductive material is placed within the cavity, wherein the material has a conductivity and a thickness which render the total conductance in the xy-plane within the cavity to be isotropic. The total electric conductance comprises the conductance of the patient and the conductance of the material.

The additional material has a thickness and an electric conductivity which is chosen to have such a value that the total electric conductance for all radial directions is the same within the xy-plane. This leads to a planar isotropy of the electric conductance in the xy-plane, which in turn reduces the inhomogeneity of the RF field.

As can be derived from the explanations above the system for magnetic resonance imaging might be an MRI apparatus or a radio frequency coil for magnetic resonance imaging.

A couple of possibilities exist to position the material within the cavity. Investing in additional holding devices within the cavity is one possibility. It is however easier if at least a part of the material is attached to an inner wall of the cylindrical cavity. When referring to the circular plane of section of the cavity with the xy-plane, the material can be fastened to a segment of the inner wall.

In addition at least a part of the material can be attached to a bottom of a substantially plane surface (the patients bed) on which the subject can be positioned. The material may then be an integral part of the patients bed.

For medical diagnosis it is not always the whole body of the patient which needs to be examined, but it may only be the abdomen, the spine, or the patients head. As the geometry of the region of interest is different in these cases, a more flexible compensation as mentioned above is possible if the electrically conductive material is removably attached within the cavity, for example to the inner wall of the cavity or to the patients bed as described above. In this case the dimensions and/or the conductivity of the material in the x-direction and in the y-direction can be adapted to the circumstances.

For practical reasons the material is only placed substantially above and below the subject to be examined, as this is sufficient in the case of a patient lying on the patients bed. In this case the patient is aligned parallel to the z-axis, and the extension of his body within the xy-plane is not circular. Although the extension of a very well nourished person within this xy-plane might approximately be circular, most people could be modelled as an ellipse fitting within the aforementioned circle. A region exists between a body in the form of the cylinder and a body having such an extension in the xy-plane. Inhomogeneity arises because this region, which is not symmetric with respect to the z-axis, is not filled with human tissue. The material being placed in the cavity thus has the function to compensate for this region of missing conductance to ensure that the conductance within the xy-plane is isotropic.

From the above explanations it can be seen that the region of missing conductance are two sickle-shaped regions facing the back and chest of the person. In the simplest case the electrically conductive material is placed only above and below the patient to compensate for these two sickle-shaped regions. Placing electrically conductive material to the left and to the right of the patient lying on the patients bed is in most cases not necessary.

Another possibility to position the material in the cavity is to place the material on top of and/or beneath the patient. This can be done by choosing a material being shaped as a sheet. At least a part of the patient's body can be covered by such a sheet which is used like a blanket.

Experiments have shown that a good compensation can be achieved with a material having a planar resistance between about 5 Ω and about 20 Ω.

It is preferred that the material above the subject to be examined has a lower planar resistance than the material below the subject. This is advantageous when the whole body of a patient needs to be examined, as for reasons of anatomy the compensation in the y-direction must be different from the compensation in the (-y)-direction.

Experiments have shown that a good compensation can be achieved with a material above the subject having a planar resistance between about 5 Ω, and about 1Ω, and a material below the subject which has a planar resistance of between about 12Ω and about 16Ω.

Numerous materials known in the prior art can be chosen for the above-mentioned compensation. The material can be a sheet which is at least partially covered by a conductive layer, for example a carbon-coated sheet of plastic. Such a sheet or foil can be attached to the inner bore of the cavity and/or the patients bed.

Furthermore it is possible that the above-mentioned material, for example a sheet, is not part of the MRI apparatus or the coil, but is a part separate and distinct from it. The patient may then lie on such an auxiliary material and/or he is partly covered by additional material. In the case of a sheet of electrically conductive material this auxiliary sheet can be used similar to a blanket. In this case the electrically conducting material can be used for improving the homogeneity of the RF field in the MRI system. This use is particularly helpful in cases in which the apparatus is designed to operate at magnetic fields of at least 3 tesla.

While it is generally desired to have a homogeneous RF field within the cavity, deliberate inhomogeneity may be an option in particular circumstances. In such a case a patterned material can be used which has local variations of its electric conductivity. As an example a sheet can be chosen of which only predetermined parts of its surface are covered by a conductive layer. Such a pattern can for example be achieved by a chemical vapour deposition process.

Embodiments of a system for magnetic resonance imaging in accordance with the invention are described in detail in the following with reference to the drawings, in which
Fig. 1 shows a top side view of an RF coil according to the invention;
Fig. 2 shows the interior of the RF coil of Fig. 1 when seen in the z-direction; and
Fig. 3 shows an MRI apparatus in accordance with the invention.

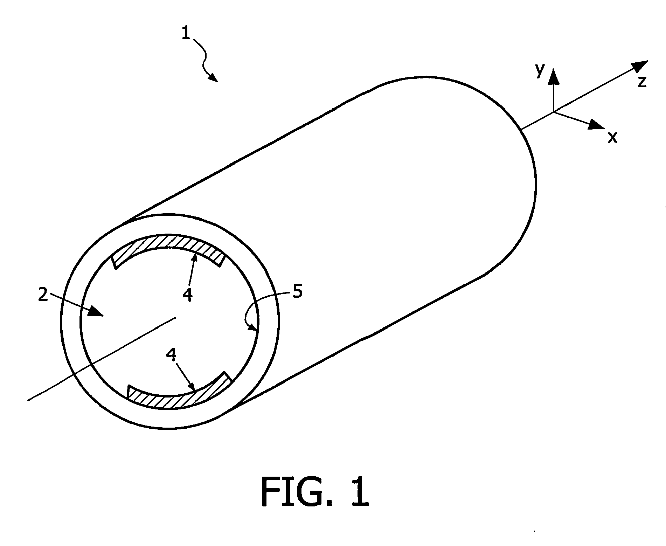

Figure 1 shows a cylindrical birdcage coil 1 in accordance with the invention having its axis of symmetry along the z-direction. The opening of the coil 1 forms the xy-plane which is perpendicular to the z-axis. The interior of the coil 1 defines the cavity 2.

This coil 1 is equipped with an electrically conducting material 4 fastened to the inner wall 5. The plane of section between the xy-plane and the coil is a circle, the inner boundary of which is partially covered by the material 4. The material 4 forms an upper and a lower segment.

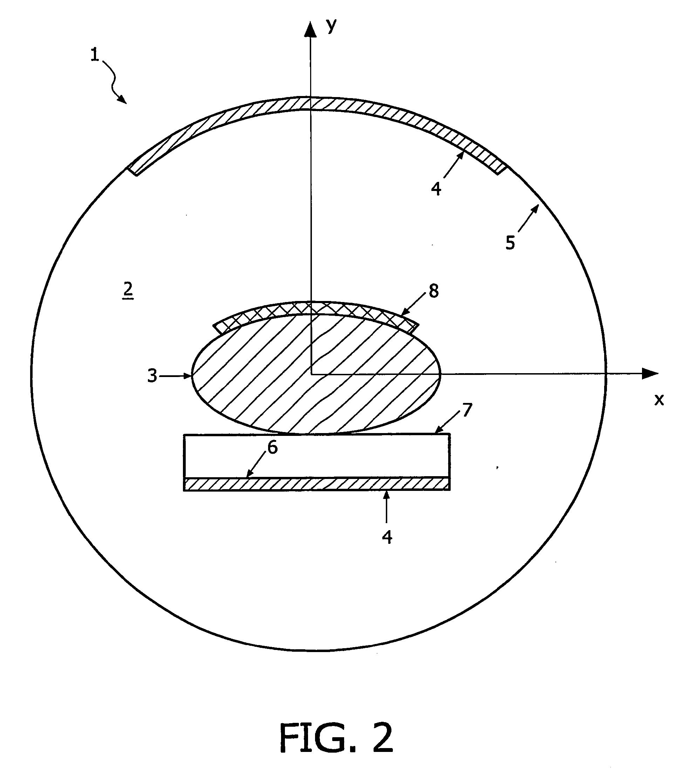

Figure 2 shows the coil 1 of Figure 1 when looking in the z-direction. Coil 1 has a substantially plane surface 7 as the upper surface of the patients bed. The patient 3 is shown in a highly simplified way as an oval body, as the shape of a human body within the xy-plane can be approximated in this way. The electrically conducting material 4 is attached to the inner wall 5 of coil 1, as well as below the bottom 6 the patients bed.

The patient 3 is covered by a plastic sheet 8 which has a carbon coating (not shown). In experiments with a saline phantom, which mimicks size, aspect ratio and conductivity of a human body, good results were obtained when the sheet 8 had a planar resistance of 8Ω when placed at the top of the patient 3, and about 12 Ω to 16 Ω when placed at the bottom of the phantom. The sheets had a length of 70 cm in the form of an alternating sequence of 5 cm and 10 cm wide strips with a gap between them. The sheet at the bottom was the same with the difference, that the gaps between the strips were very narrow.

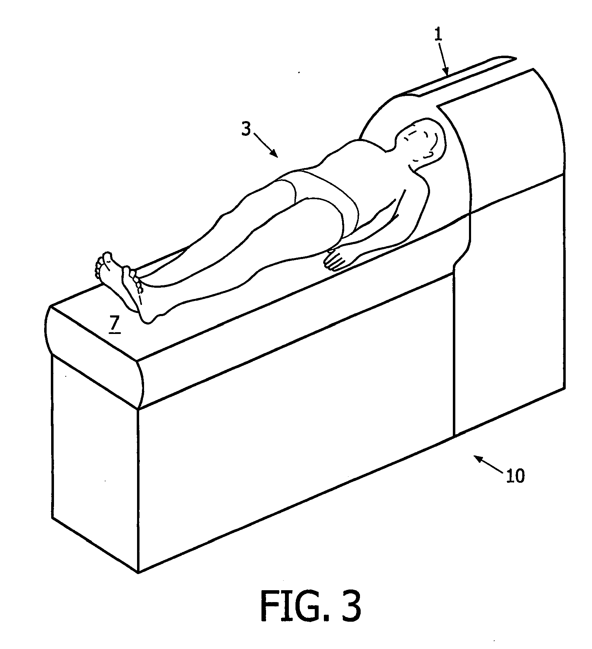

Figure 3 shows an MRI apparatus 10 in accordance with the invention being equipped with a coil 1. The apparatus 10 has a bed with a surface 7 on which the patient lies. The figure shows an application in which only the head of the patient is examined, for example to enable the diagnosis of a tumour in the patients head.

Particularly spine-imaging may suffer from inhomogeneities of the *̅B̅*̅₁ -field. The underlying reason is that the spine may exactly coincide with black spot found in MRI images which stem from regions with inhomogeneous radio frequency field. For such application it may be advantageous to place an electrically conducting sheet in an asymmetric fashion. Experiments with two sheets having a planar resistance of 9 Ω being 10 cm wide, and being placed beneath the phantom proved to be successful. The hotspots were lowered at the expense of the reduced intensity elsewhere.

## Claims

1. A system for magnetic resonance imaging, comprising:
- a substantially cylindrical cavity (2);
- wherein the cavity (2) has an axis of symmetry in the direction of a z-axis;
- wherein a subject (3) can be examined within the cavity;
- wherein the subject (3) has a conductance which is not isotropic in an xy-plane which is perpendicular to the z-axis;
**characterized in that** an electrically conductive material (4) is placed within the cavity (2), wherein the material (4) has a conductivity and a thickness which render the total conductance in the xy-plane within the cavity to be isotropic.

2. A system according to claim 1, **characterized in that** the system is a magnetic resonance imaging apparatus or a radio frequency (RF) coil for magnetic resonance imaging.

3. A system according to claim 2, **characterized in that** at least a part of the material (4) is attached to an inner wall (5) of the cylindrical cavity (2).

4. A system according to claim 1, **characterized in that** at least a part of the material (4) is attached to a bottom (6) of a substantially plane surface (7) on which the subject (3) can be positioned.

5. A system according to claim 4, **characterized in that** the substantially plane surface (7) is part of a patient's bed.

6. A system according to claim 3, 4 or 5, **characterized in that** the electrically conductive material (4) is removably attached within the cavity (2).

7. A system according to claim 1, **characterized in that** the material (4) is substantially above and below a substantially plane surface (7) on which the subject (3) can be positioned.

8. A system according to claim 1, **characterized in that** the material (4) has a planar resistance between about 5 Ω and about 2Ω.

9. A system according to claim 7, **characterized in that** the material above the subject (3) has a planar resistance between about 5 Ω and about 10Ω.

10. A system according to claim 7, **characterized in that** the material below the subject (3) has a planar resistance between about 12 Ω and about 1Ω.

11. A system according to claim 1, **characterized in that** the material (4) is a sheet (8) being covered by a conductive layer (9).

12. A system according to claim 11, **characterized in that** only predetermined parts of the sheet (8) are covered by a conductive layer (9).

13. A system according to claim 1, **characterized in that** it is arranged to operate with magnetic fields at or above 3 tesla.

## Patentansprüche

1. System zur Magnetresonanzbildgebung, das Folgendes umfasst:
- einen im Wesentlichen zylindrischen Hohlraum (2);
- wobei der Hohlraum (2) eine Symmetrieachse in Richtung einer z-Achse hat;
- wobei ein Objekt (3) innerhalb des Hohlraums untersucht werden kann;
- wobei das Objekt (3) eine Konduktanz hat, die in einer xy-Ebene, welche senkrecht zur z-Achse verläuft, nicht isotrop ist;
**dadurch gekennzeichnet, dass** ein elektrisch leitfähiges Material (4) innerhalb des Hohlraums (2) angeordnet ist, wobei das Material (4) eine Leitfähigkeit und eine Dicke hat, die die Gesamtkonduktanz in der xy-Ebene innerhalb des Hohlraums isotrop werden lassen.

2. System nach Anspruch 1, **dadurch gekennzeichnet, dass** das System ein Magnetresonanz-Bildgebungsgerät oder eine Hochfrequenzspule (HF-Spule) für die Magnetresonanzbildgebung ist.

3. System nach Anspruch 2, **dadurch gekennzeichnet, dass** mindestens ein Teil des Materials (4) an einer Innenwand (5) des zylindrischen Hohlraums (2) angebracht ist.

4. System nach Anspruch 1, **dadurch gekennzeichnet, dass** mindestens ein Teil des Materials (4) an einem Boden (6) einer im Wesentlichen ebenen Oberfläche (7) angebracht ist, auf der das Objekt (3) positioniert werden kann.

5. System nach Anspruch 4, **dadurch gekennzeichnet, dass** die im Wesentlichen ebene Oberfläche (7) Teil einer Patientenliege ist.

6. System nach Anspruch 3, 4 oder 5, **dadurch gekennzeichnet, dass** das elektrisch leitfähige Material (4) innerhalb des Hohlraums (2) entfernbar angebracht ist.

7. System nach Anspruch 1, **dadurch gekennzeichnet, dass** sich das Material (4) im Wesentlichen über und unter einer im Wesentlichen ebenen Oberfläche (7) befindet, auf der das Objekt (3) positioniert werden kann.

8. System nach Anspruch 1, **dadurch gekennzeichnet, dass** das Material (4) einen planaren Widerstand zwischen ca. 5 Ω und ca. 20 Ω hat.

9. System nach Anspruch 7, **dadurch gekennzeichnet, dass** das Material über dem Objekt (3) einen planaren Widerstand zwischen ca. 5 Ω und ca. 10 Ω hat.

10. System nach Anspruch 7, **dadurch gekennzeichnet, dass** das Material unter dem Objekt (3) einen planaren Widerstand zwischen ca. 12 Ω und ca. 16 Ω hat.

11. System nach Anspruch 1, **dadurch gekennzeichnet, dass** das Material (4) eine Folie (8) ist, die mit einer leitenden Schicht (9) bedeckt ist.

12. System nach Anspruch 11, **dadurch gekennzeichnet, dass** nur vorgegebene Teile der Folie (8) mit einer leitenden Schicht (9) bedeckt sind.

13. System nach Anspruch 1, **dadurch gekennzeichnet, dass** es dafür eingerichtet ist, mit Magnetfeldern von oder über 3 Tesla betrieben zu werden.

## Revendications

1. Système d'imagerie par résonance magnétique, comprenant:
une cavité sensiblement cylindrique (2);
dans lequel la cavité (2) présente un axe de symétrie dans la direction d'un axe z;
dans lequel un sujet (3) peut être examiné dans la cavité;
dans lequel le sujet (3) a une conductance qui n'est pas isotrope dans un plan xy qui est perpendiculaire à l'axe z;
**caractérisé en ce qu'**un matériau électriquement conducteur (4) est placé dans la cavité (2), le matériau (4) ayant une conductivité et une épaisseur qui rendent isotrope la conductance totale dans le plan xy dans la cavité.

2. Système suivant la revendication 1, **caractérisé en ce que** le système est un appareil d'imagerie par résonance magnétique ou une bobine radiofréquence (RF) pour l'imagerie par résonance magnétique.

3. Système suivant la revendication 2, **caractérisé en ce qu'**au moins une partie du matériau (4) est fixée à une paroi interne (5) de la cavité cylindrique (2).

4. Système suivant la revendication 1, **caractérisé en ce qu'**au moins une partie du matériau (4) est fixée au-dessous (6) d'une surface sensiblement plane (7) sur laquelle le sujet (3) peut être placé.

5. Système suivant la revendication 4, **caractérisé en ce que** la surface sensiblement plane (7) fait partie d'un lit d'un patient.

6. Système suivant la revendication 3, 4 ou 5, **caractérisé en ce que** le matériau électriquement conducteur (4) est fixé de manière amovible à l'intérieur de la cavité (2).

7. Système suivant la revendication 1; **caractérisé en ce que** le matériau (4) se trouve sensiblement au-dessus et au-dessous d'une surface pratiquement plane (7) sur laquelle le sujet (3) peut être placé.

8. Système suivant la revendication 1, **caractérisé en ce que** le matériau (4) a une résistance planaire comprise entre environ 5 Ω et environ 20 Ω.

9. Système suivant la revendication 7, **caractérisé en ce que** le matériau présent au-dessus du sujet (3) a une résistance planaire comprise entre environ 5 Ω et environ 10 Ω.

10. Système suivant la revendication 7, **caractérisé en ce que** le matériau présent au-dessous du sujet (3) a une résistance planaire comprise entre environ 12 Ω et environ 16 Ω.

11. Système suivant la revendication 1, **caractérisé en ce que** le matériau (4) est une feuille (8) recouverte d'une couche conductrice (9).

12. Système suivant la revendication 11, **caractérisé en ce que** seules des parties prédéterminées de la feuille (8) sont recouvertes d'une couche conductrice (9).

13. Système suivant la revendication 1, **caractérisé en ce qu'**il est agencé pour fonctionner avec des champs magnétiques de 3 tesla ou de plus de 3 tesla.
